(19)

Europäisches
Patentamt
European
Patent Office
Office européen
des brevets

(11) **EP 2 541 621 A1**

(12) **EUROPEAN PATENT APPLICATION**
published in accordance with Art. 153(4) EPC

(43) Date of publication:
**02.01.2013 Bulletin 2013/01**

(21) Application number: **11747575.6**

(22) Date of filing: **24.02.2011**

(51) Int Cl.:
**H01L 31/042** (2006.01)

(86) International application number:
**PCT/JP2011/054833**

(87) International publication number:
**WO 2011/105623 (01.09.2011 Gazette 2011/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.02.2011   JP 2011021268
25.02.2010   JP 2010040722**

(71) Applicant: **Nisshinbo Holdings Inc.
Tokyo 103-8650 (JP)**

(72) Inventors:
- **NAKAHAMA Hidenari
Aichi 4448560 (JP)**
- **IIDA Hirotaka
Aichi 4448560 (JP)**
- **NAKANO Hiroshi
Aichi 4448560 (JP)**

(54) **DIAPHRAGM SHEET**

(57) Disclosed is a novel diaphragm sheet for a solar cell module laminator. The durability is tremendously enhanced as compared with the conventional products, and making a solar cell module laminator maintenance-free over a long period of time is realized. The diaphragm sheet is composed of an olefin based rubber and has a Shore A hardness of from 35 to 80 and a thickness of from 2.0 to 6.0 mm. The olefin based rubber is, for example, an ethylene-propylene-diene rubber (EPDM) and/or an ethylene/propylene rubber (EPM).

EP 2 541 621 A1

**Description**

TECHNICAL FIELD

The present invention is an invention related to a diaphragm sheet for a solar cell module laminator.

BACKGROUND ART

In general, a solar cell element is used as a module sealed in some kind of a container or a resin so as to avoid influences of moisture or dust and endure collision of hail, pebble, etc., or wind pressure. For example, a module which is called a single-sheet structure of face sheet has a structure in which a solar cell element and an encapsulant are sealed between a glass sheet and a back sheet. The members are bonded using a laminator for a solar cell module. In a bonding step by the laminator, a laminate composed of a glass, an element, an encapsulant, and a back sheet is heated in a state of being pressed by a diaphragm, thereby achieving heat fusion and crosslinking reaction of the encapsulant. For the laminator, a vacuum laminator is used as disclosed in, for example, JP-B-4-65556.

For the encapsulant of the module, an ethylene vinyl acetate resin (EVA) is widely used. A crosslinking agent such as an organic peroxides, etc. is contained in the EVA resin, and the fusion and crosslinking reaction are achieved upon heating by the laminator. Though the heat fusion and crosslinking are conducted at a temperature of from about 120 to 170 °C, they can be achieved at a temperature higher than the foregoing temperature for the purpose of promoting the crosslinking reaction.

As described previously, the diaphragm sheet is required to have flexibility for the purpose of keeping the vacuum upon being pressed and is also required to have heat resistance so as to endure the processing temperature. For that reason, a silicone rubber has hitherto been widely used (Patent Document 1). In addition, there is also disclosed the use of a butyl rubber (Patent Document 2).

[Patent Document 1] JP4-65556B
[Patent Document 2] International Publication No. WO/2004/030900

SUMMARY OF THE INVENTION

PROBLEMS TO BE SOLVED BY THE INVENTION

However, there is involved such a problem that a gas containing an organic peroxide as a crosslinking agent, and the like is emitted from the EVA resin by heating, thereby deteriorating the diaphragm sheet in the surroundings of the members. In the case of a silicone sheet, it is hardened by a short-term laminating working and loses the flexibility, thereby causing fissure or cracking, and hence, it need to be disposed or exchanged. An increase of manufacturing costs of a solar cell to be caused due to frequent exchange of an expensive silicone sheet and a lowering of productivity to be caused due to time for exchanging a large-area diaphragm sheet are problematic, too.

Patent Document 2 describes that the life is prolonged approximately twice by the use of a butyl rubber as compared with the conventional technologies; however, satisfactory durability is not available yet. In addition, since the butyl rubber is easily softened at a high temperature at the time of laminator processing and becomes tacky, the handling becomes difficult, and furthermore, there is involved such a problem that a part of the softened butyl rubber pollutes the module product and the laminator itself.

In view of the foregoing problems, an object of the present invention is to provide a diaphragm sheet which is tremendously improved in durability, which is free from tackiness to a release sheet or a module to be caused due to an increase of the tackiness at the time of use at a high temperature, and which is easy in handling, thereby realizing to make a solar cell module laminator maintenance-free over a long term.

MEANS FOR SOLVING THE PROBLEMS

In order to attain the foregoing object, the present inventors found that the durability in a diaphragm sheet is tremendously enhanced by using an olefin based rubber having specified hardness and thickness, furthermore, forming a specified polymer composition, and moreover, adjusting a content of a specified stabilizer to a prescribed range and then they accomplished the present invention.

Specifically, the present invention provides:

(1) A diaphragm sheet for a solar cell module laminator comprising an olefin based rubber and having a Shore A hardness of from 35 to 80 and a thickness of from 2.0 to 6.0 mm;

(2) The diaphragm sheet as set forth in (1), wherein the olefin based rubber is (A) an ethylene-propylene-diene rubber (EPDM) and/or (B) an ethylene-propylene rubber (EPM);

(3) The diaphragm sheet as set forth in (2), wherein an ethylene mole % is from 60 to 80 % by mole and a diene content is from 0 to 30 in terms of an iodine number within the molecules of the (A) and (B) components;

(4) The diaphragm sheet as set forth in (2) or (3), wherein a blending ratio (A)/(B) of the component (A) to the component (B) in the olefin based rubber is from 100/0 to 30/70;

(5) The diaphragm sheet as set forth in (1) to (4), wherein a heat-resistant stabilizer is contained in the olefin based rubber, and the stabilizer is contained within a depth of 2 mm from at least one surface of the diaphragm sheet in the amount of from 0.1 to 5.0 wt%;

(6) The diaphragm sheet as set forth in (5), wherein the heat-resistant stabilizer is an antioxidant;

(7) The diaphragm sheet as set forth in (6), wherein the antioxidant is a phenol based antioxidant or an arbitrary combination of a phenol based antioxidant with a phosphite based antioxidant, a thioether based antioxidant, or an amine based antioxidant;

(8) The diaphragm sheet as set forth in (7), wherein a hindered phenol based antioxidant is used as the antioxidant, and a molecular weight of the hindered phenol based antioxidant is 400 or more;

(9) The diaphragm sheet as set forth in (5) to (8), wherein a content rate of the heat-resistant stabilizer within a depth of 2 mm from one surface of the diaphragm sheet is from 1.1 to 3.0 times a content rate in other portion;

(10) The diaphragm sheet as set forth in (1) to (9), wherein a crosslinking density thereof is from $0.1 \times 10^{-4}$ to $10 \times 10^{-4}$ moles/cm$^3$;

(11) The diaphragm sheet as set forth in (1) to (10), wherein an inorganic filler is coated on at least one surface thereof; and

(12) The diaphragm sheet as set forth in (11), wherein the inorganic filler is talc and/or mica having a platy shape.

An EVA resin that is a encapsulant of the solar cell module contains a crosslinking agent such as an organic peroxide, etc. Though fusion and crosslinking are achieved upon heating of a laminator, at that time, a gas containing the crosslinking agent leaks out in the surroundings of the solar cell members. The olefin based rubber of the present invention is excellent in the durability against this gas. In addition, a diaphragm sheet of a vacuum laminator is required to have flexibility for achieving a close contact with the members and heat resistance against the processing temperature. The present inventors have found that by determining the olefin based rubber to have a Shore A hardness of from 35 to 80, it can be used as the diaphragm sheet. When the Shore A hardness is less than 35, there is a problem that a press of the module and a close contact with the members are not achieved well because the sheet is easily warped. When the Shore A hardness exceeds 80, there is a problem that the diaphragm sheet is easily broken because the sheet is too hard. When the thickness is less than 2.0 mm, there is a problem that a load is dispersed because of a weak pressing pressure. When the thickness exceeds 6.0 mm, there is a problem that the pressing becomes a point load so that uniform pressurization cannot be achieved because of poor flexural properties.

The olefin based rubber is suitably (A) an ethylene-propylene-diene copolymer rubber (EPDM) and/or (B) an ethylene-propylene rubber (EPM). This is because these are preferable from the standpoint of durability against a gas emitted from EVA.

In addition, the present invention has such characteristic features that an ethylene mole % is from 60 to 80 % by mole; and that a diene content is from 0 to 30 in terms of an iodine number, within the molecules constituting the olefin based rubber.

The "mole %" as referred to herein is a value on the basis of an ethylene-propylene structural unit exclusive of the diene. When the ethylene mole % is less than 60 % by mole, the sheet is too soft because the modulus of the sheet is too low; whereas when it exceeds 80 % by mole, the rubber-like properties are lowered. In all of these cases, there is a problem at the time of pressing of the module. When the value of the iodine number exceeds 30, the diaphragm (rubber) sheet is easily oxidized to cause a problem of durability life to be caused due to a lowering of the heat resistance.

A blending weight ratio (A)/(B) of the component (A) to the component (B) in the olefin based rubber is suitably from 100/0 to 30/70. When the blending weight ratio is less than 30/70, namely, the component (A) is less than 30, a crosslinking density of the diaphragm sheet is lowered, so that the functions as a diaphragm cannot be accomplished.

For the purpose of enhancing the heat resistance, it is suitable that a heat-resistant stabilizer is contained in the olefin based rubber, and it is suitable that the stabilizer is contained within a depth of 2 mm from at least one surface of the diaphragm sheet in the amount of from 0.1 to 5.0 wt%. In carrying out the invention, the diaphragm sheet is set in a laminator and used in such a manner that the subject surface is located on the side coming into contact with the module. This is because when a prescribed amount of the heat-resistant stabilizer is not present within a depth of 2 mm from at least one surface thereof, the durability against a gas emitted from EVA is inferior. In addition, when the amount of the heat-resistant stabilizer is less than 0.1 wt%, the sufficient effects cannot be exhibited. When it exceeds 5.0 wt%, there is a possibility that the crosslinking density at the time of manufacturing a diaphragm sheet is lowered, so that a compressing function is lowered.

For the purpose of trapping a radical of the organic peroxide in the gas emitted from EVA, it is suitable to use, as the heat-resistant stabilizer, a phenol based antioxidant or an arbitrary combination of a phenol based antioxidant with a phosphite based antioxidant, a thioether based antioxidant, or an amine based antioxidant. Above all, the case of an arbitrary combination of plural members is more effective.

In the case of using a hindered phenol based antioxidant that is one kind of the phenol based antioxidant, one having a molecular weight of 400 or more is preferable from the standpoint of heat resistance. In addition to the standpoint of heat resistance, when the molecular weight is not more than 400, there may be the case where a phenomenon in which scattering or vaporization, or extraction into a substance with which the antioxidant comes into contact, occurs is observed. In consequence, one having a molecular weight of 400 or more is preferably used, and one having a molecular weight of 500 or more is more preferable. In addition, by selecting one having a high molecular weight, there also gives rise to an effect that the heat resistance of the composition can be enhanced.

Examples of such a hindered phenol based antioxidant having a molecular weight of 400 or more include 4,4'-methylene-bis-(2,6-di-t-butylphenol) (MW = 420), octadecyl-3-(3,5-di-t-butyl-4-hydroxyphenyl)propionate (MW = 531) (a trade name: IRGANOX 1076, available from Ciba Specialty Chemicals Inc.), pentaerythritol tetrakis[3-(3,5-di-t-butyl-4-hydroxyphenyl)propionate] (MW = 1,178) (a trade name: IRGANOX 1010, available from Ciba Specialty Chemicals Inc.), 3,9-bis[2-[3-(3-t-butyl-4-hydroxy-5-methylphenyl)propionyloxy]-1,1-dimethylethyl]-2,4,8,10-tetraoxaspiro[5.5]undecane (MW = 741) (a trade name: SUMILIZER GA-80, available from Sumitomo Chemical Co., Ltd.), and so on.

Examples of the phosphite based antioxidant include tris-(2,4-di-t-butylphenyl)phosphite (a trade name: IRGAFOS 168, available from Ciba Specialty Chemicals Inc.; a trade name: ADEKA STAB 2112, available from Adeka Corporation; etc.), bis-(2,4-di-t-butylphenyl)pentaerythritol-diphosphite (a trade name: IRGAFOS 126, available from Ciba Specialty Chemicals Inc.; a trade name: ADEKA STAB PEP-24G, available from Adeka Corporation; etc.), bis-(2,6-di-t-butyl-4-methylphenyl)pentaerythritol-diphosphite (a trade name: ADEKA STAB PEP-36, available from Adeka Corporation), distearyl-pentaerythritol-diphosphite (a trade name: ADEKA STAB PEP-8, available from Adeka Corporation; a trade name: JPP-2000, available from Johoku Chemical Co., Ltd.; etc.), and so on. From the standpoint of an enhancement of hydrolysis resistance, those having a pentaerythritol structure are preferable, and those further having an aromatic hydrocarbon group containing a t-butyl group in addition to the pentaerythritol structure are especially preferable.

Examples of the thioether based antioxidant include 2,2-bis({[3-(dodecylthio)propionyl]oxy}methyl)-1,3-propanediyl=bis[3-(dodecylthio)propionate] (a trade name: ADEKA STAB AO-412S, available from Adeka Corporation), ditridecan-1-yl=3,3'-sulfanediyl dipropanoate (a trade name: ADEKA STAB AO-503, available from Adeka Corporation), and so on.

As the amine based antioxidant, there can be exemplified aromatic amine based compounds such as diphenylamine, phenyl α-naphthylamine, etc. These can be used in combination with the foregoing hindered phenol based antioxidant or phosphite based antioxidant so far as the effects of the present invention are not inhibited.

It is suitable from the standpoint of durability against the gas emitted from EVA that the heat-resistant stabilizer in an amount falling within a certain range is contained within a depth of 2 mm from one surface of the diaphragm sheet. This is because the deterioration of the diaphragm sheet occurs from the surface due to the matter that the sheet surface absorbs the gas emitted from EVA. In addition, since the cost of the heat-resistant stabilizer is expensive, leading to an increase of the product cost, it is desirable that the concentration is high only in a necessary place. The present invention has such a characteristic feature that a content rate of the heat-resistant stabilizer in the former site is from 1.1 to 3.0 times the content rate of the latter site. When it is less than 1.1 times, the heat-resistant stabilizer is contained uniformly over the whole of the diaphragm, so that the economy is impaired. When it exceeds 3.0 times, there is caused a problem that the molding processability becomes worse because the crosslinking density in a crosslinking step of the diaphragm sheet becomes low, resulting in causing a fault such as tackiness, etc.

In addition, the diaphragm sheet of the present invention has such a characteristic feature that a crosslinking density thereof is from $0.1 \times 10^{-4}$ to $10 \times 10^{-4}$ moles/cm$^3$. When the crosslinking density is less than $0.1 \times 10^{-4}$ moles/cm$^3$, there is a problem that a press of the module and a close contacting with the members are not achieved well because the sheet is easily warped. When the crosslinking density exceeds $10 \times 10^{-4}$ moles/cm$^3$, there is caused a problem that the diaphragm sheet is easily broken because the sheet is too hard. Incidentally, for the crosslinking of the diaphragm sheet, diacyl peroxide based, oxy ester based, and perketal based materials which are generally known as organic peroxide crosslinking agents and crosslinking aids are preferably used. In addition, as the crosslinking aid, triallyl isocyanurate, triallyl cyanurate, p,p-dibenzoyl quinone dioxime, p-quinone dioxime, 1,2-polybutadiene, trimethylolpropane trimethacrylate, and ethylene dimethacrylate are preferably used. These organic peroxides and crosslinking aids are all used for the crosslinking reaction and decomposed at the time of manufacturing and molding of a diaphragm sheet.

In addition, from the standpoint of preventing sticking to a conveyance sheet at the time of a high temperature, it is preferable to coat an inorganic filler on at least one surface of the diaphragm sheet of the present invention. As for a coating method of an inorganic filler, for example, by using an apparatus that physically adsorbs talc onto a roll and applies it while rotating the roll, talc is coated on an uncrosslinked sheet, and thereafter, pressure and temperature are given at a temperature of from 100 °C to 220 °C for from 10 minutes to 60 minutes with a rote-cure type crosslinking machine or a pressing machine. Examples of the inorganic filler include, in addition to talc, silicic anhydride, hydrous silicic acid, calcium silicate, aluminum silicate, hydrous aluminum silicate, kaolinitic clay, calcium carbonate, heavy calcium carbonate, basic magnesium carbonate, alumina hydrate, diatomaceous earth, barium sulfate, mica, alumina oxide, lipothone, graphite, molybdenum dioxide, pumice powder, glass powder, and silica sand.

Above all, a filler having a platy shape, such as talc and mica, is preferable.

EFFECTS OF THE INVENTION

The diaphragm sheet of the present invention tremendously enhances the durability against a gas emitted from EVA as compared with the conventional diaphragm sheets made of silicone or a butyl rubber and contributes to realization of making a laminator maintenance-free. In addition, by replacing an expensive silicone sheet by an inexpensive raw material, the diaphragm sheet of the present invention also contributes to a reduction of manufacturing costs of a solar cell. In addition, since the diaphragm sheet of the present invention is free from poor handling and pollution of a module product and a laminator itself as seen in a butyl rubber sheet, it leads to an enhancement of the productivity, too.

BEST MODES FOR CARRYING OUT THE INVENTION

The present invention is specifically described with reference to Examples.

[Example 1]

50 parts by weight of (A) an ethylene-propylene-diene rubber (EPDM: MITSUI EPT4070, manufactured by Mitsui Chemicals, Inc., ethylene mole %: 68, diene content: 20 in terms of iodine number) and 50 parts by weight of (B) an ethylene-propylene rubber (EPM: MITSUI EPT0045, ethylene mole %: 68) were used as an olefin based rubber; 50 parts by weight of carbon black, 50 parts by weight of paraffin oil, 1 part by weight of stearic acid, 5 parts by weight of zinc white, and 2 parts by weight of, as a heat-resistant stabilizer, pentaerythritol tetrakis[3-(3,5-dit-butyl-4-hydroxyphenyl) propionate] (a trade name: IRGANOX 1010) that is a phenol based antioxidant were added thereto; and the contents were kneaded for 15 minutes using a kneader, thereby obtaining a compound. After the temperature reached 80 °C or less, 7 parts by weight of dicumyl peroxide (PERCUMYL D40C, manufactured by NOF Corporation) was blended to fabricate a compound for a diaphragm sheet having an amount of the heat-resistant stabilizer of 0.93 wt%. Incidentally, the iodine number of EPDM was measured in accordance with ASTM D1959-97, and the same was also applied to other Examples and Comparative Examples.

The compound for a diaphragm sheet was fabricated into a sheet having a thickness of 3.2 mm with a 26-inch roll. Talc (TALC SW, manufactured by Nippon Talc Co., Ltd.) was coated on the both surfaces of the sheet with a brush, and thereafter, the resulting sheet was molded with a mold press to fabricate a diaphragm sheet having a length of 4.2 m, a width of 2 m, and a thickness of 3.0 mm. This was set in a solar cell module laminator, LAM 1537 (manufactured by Nisshinbo Mechatronics Inc.), and a solar cell modulus manufacturing operation was carried out with an EVA sheet as an encapsulant at a processing temperature of 150 °C for a lamination time of 20 minutes as one cycle. This module manufacturing operation was repeated, and the number of times until a crack was generated at the time of pressing the module on the diaphragm sheet located in the vicinity of the periphery of the module (a portion where the amount of a gas emitted from EVA was considered to be the largest) was measured.

[Example 2]

A diaphragm sheet was fabricated in the same manner as that in Example 1, except for adding 100 parts of EPDM (MITSUI EPT4070) (ethylene mole %: 68) as the olefin based rubber, without adding EPM (MITSUI EPT0045, ethylene mole %: 68) and adding 3.0 parts by weight of IRGANOX 1010 as the heat-resistant stabilizer and 2.0 parts by weight of an amine based anti-aging agent (ANTAGE RD, manufactured by Kawaguchi Chemical Industry Co., Ltd.) as an anti-aging agent, and set in a laminator, and then the number of times until a crack was generated was measured.

[Example 3]

A diaphragm sheet was fabricated in the same manner as that in Example 1, except for using 80 parts by weight of EPDM (MITSUI EPT4070) (ethylene mole %: 68) and 20 parts by weight of EPM (MITSUI EPT0045, ethylene mole %: 68) as the olefin based rubber and changing the amount of IRGANOX 1010 as the heat-resistant stabilizer to 1 part by weight, and set in a laminator, and then the number of times until a crack was generated was measured.

[Example 4]

A diaphragm sheet was fabricated in the same manner as that in Example 1, except for using 70 parts by weight of EPDM (MITSUI EPT3072, manufactured by Mitsui Chemicals, Inc., oil extension amount: 40 parts, ethylene mole %: 78, diene content: 10 in terms of iodine number) and 50 parts by weight of EPM (MITSUI PT0045, ethylene mole %: 68) as the olefin based rubber and changing the amount of the paraffin oil and the amount of IRGANOX 1010 as the heat-resistant stabilizer to 30 parts by weight and 1 part by weight, respectively, and set in a laminator, and then the number of times until a crack was generated was measured.
For the purpose of taking compatibility with the description in the table, the EPDM amount was amended to 70 parts by weight.

[Example 5]

A diaphragm sheet was fabricated in the same manner as that in Example 1, except for using 30 parts by weight of EPDM (MITSUI EPT4070, ethylene mole %: 68) and 70 parts by weight of EPM (MITSUI EPT0045, ethylene mole %: 68) as the olefin based rubber and changing the amount of IRGANOX 1010 as the heat-resistant stabilizer to 1 part by weight, and set in a laminator, and then the number of times until a crack was generated was measured.

[Comparative Example 1]

SR952T, manufactured by Kureha Elastomer Co., Ltd. (Shore A hardness: 50, thickness: 3.0 mm) as a diaphragm sheet made of silicone as a raw material was set in a laminator, and then the number of times until a crack was generated was measured.

[Comparative Example 2]

A compound for a diaphragm sheet having a Shore A hardness of 82 was fabricated in the same manner as that in Example 3, except for using 20 parts by weight of EPDM (MITSUI EPT4070, ethylene mole %: 68) and 80 parts by weight of EPM (MITSUI EPT0045, ethylene mole %: 68) as the olefin based rubber and changing the amount of carbon black and the amount of the paraffin oil to 140 parts by weight and 50 parts by weight, respectively, and molded in the same manner as that in Example 3, except for not coating talc, thereby fabricating a diaphragm sheet. The diaphragm sheet was set in a laminator in the same manner as that in Example 1, and then the number of times until a crack was generated was measured.

[Comparative Example 3]

A compound for a diaphragm sheet having a Shore A hardness of 30 was fabricated in the same manner as that in Example 3, except for using 20 parts by weight of EPDM (MITSUI EPT4070, ethylene mole %: 68) and 80 parts by weight of EPM (MITSUI EPT0045, ethylene mole %: 68) as the olefin based rubber and changing the amount of carbon black and the amount of the paraffin oil to 50 parts by weight and 90 parts by weight, respectively, and molded in the same manner as that in Example 3, except for not coating talc, thereby fabricating a diaphragm sheet. Incidentally, the thickness was changed to 7.0 mm. The diaphragm sheet was set in a laminator in the same manner as that in Example 1, and then the number of times until a crack was generated was measured.
As for Examples 1 to 4 and Comparative Examples 1 to 3, the composition and physical properties of each of the diaphragm sheets and results of the number of times until a crack was generated are shown in Table 1.

[Example 6]

A compound for a diaphragm sheet was fabricated in the same manner as that in Example 1, except for using 100 parts by weight EPDM (MITSUI 3090E, manufactured by Mitsui Chemicals, Inc.) as the olefin based rubber, without adding EPM and changing the amount of IRGANOX 1010 as the heat-resistant stabilizer, the amount of carbon black, and the amount of the paraffin oil to 8.6 parts by weight, 50 parts by weight, and 60 parts by weight, respectively. In addition, a compound for a diaphragm sheet was fabricated in the same manner as that in Example 1, except for changing the amount of IRGANOX 1010 as the heat-resistant stabilizer, the amount of carbon black, and the amount of the paraffin oil to 6.7 parts by weight, 50 parts by weight, and 60 parts by weight, respectively. These two kinds of compounds for a diaphragm sheet were molded in a sheet form in the same manner as that in Example 1, except for not coating talc. Subsequently, these two kinds of sheets were stacked and then molded with a mold press, thereby fabricating a diaphragm sheet (thickness: 3 mm) in which the content of the heat-resistant stabilizer within a depth of 2 mm from one surface thereof was 3.7 wt%, and the content rate of the heat-resistant stabilizer within a depth of 2 mm of one surface thereof was 1.3 times that in other portion. A Shore A hardness of the fabricated diaphragm sheet was measured. In addition, this diaphragm sheet was set in a laminator in such a manner the surface on the side where the amount of the heat-resistant stabilizer of the sheet was larger was located on the side coming into contact with the module, and the number of times until a crack was generated was measured in the same manner as that in Example 1. The composition and physical properties of the diaphragm sheet of Example 6 and results of the number of times until a crack was generated are shown in Table 2. Incidentally, the crosslinking density is one measured by the following method which is called a solvent swelling method (Flory-Rehner method).

A test piece of 20 mm $\times$ 20 mm $\times$ 3 mm was punched out from the diaphragm sheet; in conformity with JIS K6258 it was dipped in 100 mL of toluene at 37 °C for 72 hours so as to be swollen and the crosslinking density was then determined according to the following Flory-Rehner equation (Equation (1)) utilizing equilibrium swelling.

$$\nu = \{V_R + ln\ (1 - V_R) + \mu V_R^2\}/\{-V_0(V_R^{1/2} - V_R/2)\} \quad (1)$$

$\nu$: Crosslinking density (mole/cm$^3$)
$V_R$: Volume fraction of pure rubber in the swollen test piece
$\mu$: Interaction constant between rubber and solvent (0.49)
$V_0$: Molar volume of toluene (108.15 cm$^3$)

Incidentally, $V_R$ was determined according to the following Equation (2).

$$V_R = Vr/(Vr + Vs) \quad (2)$$

Vr: Volume of pure rubber in the test piece (cm$^3$)
Vs: Volume of solvent absorbed by the test piece (cm$^3$)

[Example 7]

A compound for a diaphragm sheet was fabricated in the same manner as that in Example 1, except for changing the amount of IRGANOX 1010 as the heat-resistant stabilizer, the amount of carbon black, and the amount of the paraffin oil to 8.6 parts by weight, 60 parts by weight, and 50 parts by weight, respectively. In addition, a compound for a diaphragm sheet was fabricated in the same manner as that in Example 1, except for changing the amount of IRGANOX 1010 as the heat-resistant stabilizer, the amount of carbon black, and the amount of the paraffin oil to 5.7 parts by weight, 60 parts by weight, and 50 parts by weight, respectively. A diaphragm sheet was fabricated in the same manner as that in Example 6 by using these two kinds of compounds for a diaphragm sheet. This was set in a laminator in the same manner as that in Example 6, and then the number of times until a crack was generated was measured.

[Example 8]

A compound for a diaphragm sheet was fabricated in the same manner as that in Example 1, except for changing the amount of IRGANOX 1010 as the heat-resistant stabilizer, the amount of carbon black, and the amount of the paraffin oil to 8.6 parts by weight, 100 parts by weight, and 50 parts by weight, respectively. In addition, a compound for a diaphragm sheet was fabricated in the same manner as that in Example 1, except for changing the amount of the heat-resistant stabilizer, the amount of carbon black, and the amount of the paraffin oil to 5.1 parts by weight, 100 parts by weight, and 50 parts by weight, respectively. A diaphragm sheet was fabricated in the same manner as that in Example 6 by using these two kinds of compounds for a diaphragm sheet and set in a laminator, and then the number of times until a crack was generated was measured.

[Example 9]

A compound for a diaphragm sheet was fabricated in the same manner as that in Example 1, except for changing the amount of IRGANOX 1010 as the heat-resistant stabilizer, the amount of carbon black, and the amount of the paraffin oil to 6.5 parts by weight, 120 parts by weight, and 40 parts by weight, respectively. In addition, a compound for a diaphragm sheet was fabricated in the same manner as that in Example 1, except for changing the amount of the heat-resistant stabilizer, the amount of carbon black, and the amount of the paraffin oil to 3.3 parts by weight, 120 parts by weight, and 40 parts by weight, respectively. A diaphragm sheet was fabricated in the same manner as that in Example 6 by using these two kinds of compounds for a diaphragm sheet and set in a laminator, and then the number of times until a crack was generated was measured.

[Comparative Example 4]

A compound for a diaphragm sheet was fabricated in the same manner as that in Example 7, except for not blending the heat-resistant stabilizer. A diaphragm sheet was fabricated in the same manner as that in Example 6 and set in a laminator, and then the number of times until a crack was generated was measured.

[Comparative Example 5]

VB260N, manufactured by Kureha Elastomer Co., Ltd. (Shore A hardness: 55, thickness: 3 mm) as a diaphragm sheet made of a butyl rubber as a raw material was set in a laminator in the same manner as that in Example 1, and then the number of times until a crack was generated was measured.

[Comparative Example 6]

SW955T, manufactured by Kureha Elastomer Co., Ltd. (Shore A hardness: 55, thickness: 3.0 mm) as a diaphragm sheet made of silicone as a raw material was set in a laminator in the same manner as that in Example 1, and then the number of times until a crack was generated was measured.

As for Examples 6 to 9 and Comparative Examples 4 to 6, the composition and physical properties of each of the diaphragm sheets and results of the number of times until a crack was generated are shown in Table 2.

[Examples 10 to 13]

Kind and addition amount of each of heat-resistant stabilizers of Examples 10 to 13 are shown in Table 3. Each compound for a diaphragm sheet was fabricated in the same manner as that in Example 1, except for changing the kind and addition amount of the heat-resistant stabilizer. In addition, each diaphragm sheet was fabricated in the same manner as that in Example 1, except for not coating talc, and set in a laminator, and then the number of times until a crack was generated was measured. Results are shown in Table 3.

As is clear from Table 1, it is noted that the Examples of the present invention were greatly improved in the durability as compared with the conventional silicone sheet of Comparative Example 1. It is clear from the comparison with Comparative Example 5 the durability is markedly excellent as compared with the sheet made of a butyl rubber as a raw material. In addition, the diaphragm sheet of the present invention is excellent because a variety of faults to be caused due to softening of the butyl rubber sheet on a high-temperature side are not generated.

In addition, it is noted from the comparison with Comparative Examples 2 and 3 in Table 1 that the durability is greatly enhanced by determining the Shore A hardness and the thickness to fall within the ranges of the present invention, respectively.

Furthermore, it is noted from the comparison between Examples 6 to 9 in Table 2 and Example 1 in Table 1 that the durability is tremendously enhanced by taking such a constitution that the content rate of the heat-resistant stabilizer within a depth of 2 mm from one surface of the diaphragm sheet is made to be a prescribed ratio to the content rate in other portion.

Examples 10 to 13 demonstrate that the durability was enhanced by using, as the heat-resistant stabilizer, a combination of a phenol based antioxidant with a phosphite based antioxidant, a thioether based antioxidant, or an amine based antioxidant.

Table 1

| | Example 1 | Example 2 | Example 3 | Example 4 | Example 5 | Comparative Example 1 | Comparative Example 2 | Comparative Example 3 |
|---|---|---|---|---|---|---|---|---|
| Ethylene mole (%) | 68/68 | 68 | 68/68 | 78/68 | 68/68 | - | 68/68 | 68/68 |
| Diene content (iodine number) | 20/0 | 20 | 20/0 | 10/0 | 20/0 | - | 20/0 | 20/0 |
| EPDM/EPM blending ratio | 50/50 | 100/0 | 80/20 | 70/50 | 30/70 | - | 20/80 | 20/80 |
| Amount of heat-resistant stabilizer (wt%) | 0.93 | 1.38 | 0.47 | 0.47 | 0.47 | - | 0.33 | 0.39 |
| Shore A hardness | 50 | 50 | 50 | 50 | 50 | 50 | 82 | 30 |
| Thickness (mm) | 3.0 | 3.0 | 3.0 | 3.0 | 3.0 | 3.0 | 3.0 | 7.0 |
| Number of times until the generation of crack | 4959 | 7053 | 1764 | 1985 | 2650 | 1486 | 773 | 1164 |
| Talc coating | Yes | Yes | Yes | Yes | Yes | No | No | No |
| Sticking to sheet * | 3 | 3 | 3 | 3 | 3 | 3 | 2 | 1 |

* 3: Sticking is not observed at all.
2: The sheet sticks to a part of the release sheet.
1: The sheet completely sticks to the release sheet.

Table 2

| | Example 6 | Example 7 | Example 8 | Example 9 | Comparative Example 4 | Comparative Example 5 |
|---|---|---|---|---|---|---|
| Kind of rubber on the contact surface of solar cell | EPDM | EPDM/EPM | EPDM/EPM | EPDM/EPM | Butyl (IIR) | Silicone |
| Shore A hardness | 40 | 50 | 70 | 78 | 55 | 55 |
| Amount of heat-resistant stabilizer within a depth of 2 mm from one surface (wt%) | 3.7 | 3.7 | 3.2 | 3.1 | - | - |
| Ratio of the content rate of heat-resistant stabilizer within a depth of 2 mm from one surface to that in other portion | 1.3 | 1.5 | 1.7 | 2.0 | - | - |
| Crosslinking density ($10^{-4}$ mole/cc) | 2.0 | 1.8 | 1.6 | 1.4 | - | - |
| Number of times until the generation of crack | 7500 | 7000 | 6000 | 5500 | 2500 | 2400 |

Table 3

| | Example 10 | Example 11 | Example 12 | Example 13 |
|---|---|---|---|---|
| Kind of rubber | EPDM/EPM | EPDM/EPM | EPDM/EPM | EPDM/EPM |
| Shore A hardness | 50 | 50 | 50 | 50 |
| Amount of phenol based antioxidant SUMILIZER GA-80 (wt%) | 2.0 | 2.0 | 2.0 | - |
| Amount of phenol based antioxidant SUMILIZER BHT (wt%) | - | - | - | 2.0 |
| Amount of phosphite based antioxidant IRGAFOS 168 (wt%) | 2.0 | - | - | 2.0 |
| Amount of thioether based antioxidant ADEKA STUB AO-412S (wt%) | - | 2.0 | - | - |
| Amount of amine based antioxidant ANTIGEN RD (wt%) | - | - | 2.0 | - |
| Number of times until the generation of crack | 6805 | 7012 | 7293 | 5434 |

**Claims**

1.  A diaphragm sheet for a solar cell module laminator comprising an olefin based rubber and having a Shore A hardness of from 35 to 80 and a thickness of from 2.0 to 6.0 mm.

2.  The diaphragm sheet according to claim 1, wherein the olefin based rubber is (A) an ethylene-propylene-diene rubber (EPDM) and/or (B) an ethylene-propylene rubber (EPM).

3.  The diaphragm sheet according to claim 2, wherein an ethylene mole % is from 60 to 80 % by mole and a diene content is from 0 to 30 in terms of an iodine number within the molecules constituting the olefin based rubber.

4.  The diaphragm sheet according to claim 2 or 3, wherein a blending ratio (A)/(B) of the component (A) to the component (B) in the olefin based rubber is from 100/0 to 30/70.

5.  The diaphragm sheet according to claims 1 to 4, wherein a heat-resistant stabilizer is contained in the olefin based rubber, and the heat-resistant stabilizer is contained within a depth of 2 mm from at least one surface of the diaphragm sheet in an amount of from 0.1 to 5.0 wt%.

6.  The diaphragm sheet according to claim 5, wherein the heat-resistant stabilizer is an antioxidant.

7.  The diaphragm sheet according to claim 6, wherein the antioxidant is a phenol based antioxidant or an arbitrary combination of a phenol based antioxidant with a phosphite based antioxidant, a thioether based antioxidant, or an amine based antioxidant.

8.  The diaphragm sheet according to claim 7, wherein a hindered phenol based antioxidant is used as the antioxidant, and a molecular weight of the hindered phenol based antioxidant is 400 or more.

9.  The diaphragm sheet according to claims 5 to 8, wherein a content rate of the heat-resistant stabilizer within a depth of 2 mm from one surface of the diaphragm sheet is from 1.1 to 3.0 times a content rate in other portion.

10. The diaphragm sheet according to claims 1 to 9, wherein a crosslinking density thereof is from $0.1 \times 10^{-4}$ to $10 \times 10^{-4}$ moles/cm$^3$.

11. The diaphragm sheet according to claims 1 to 10, wherein an inorganic filler is coated on at least one surface thereof.

12. The diaphragm sheet according to claim 11, wherein the inorganic filler is talc and/or mica having a platy shape.

<div style="text-align:center">**INTERNATIONAL SEARCH REPORT**</div>

| International application No. |
|---|
| PCT/JP2011/054833 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042, B30B5/02, B29C63/00, B29C65/00

Documentation searched other than minimum documentation to the extent that such documents are included in the fields searched

| Jitsuyo Shinan Koho | 1922-1996 | Jitsuyo Shinan Toroku Koho | 1996-2011 |
|---|---|---|---|
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2004/030900 A1 (NPC Inc.),<br>15 April 2004 (15.04.2004),<br>entire text; all drawings<br>& US 2006/0289119 A1 & EP 1550548 A1<br>& AU 2002335176 A | 1-12 |
| A | JP 2000-000950 A (Canon Inc.),<br>07 January 2000 (07.01.2000),<br>paragraph [0071]<br>(Family: none) | 1-12 |
| A | JP 2001-353600 A (Inoac Corp.),<br>25 December 2001 (25.12.2001),<br>paragraph [0016]<br>(Family: none) | 1-12 |

☐ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 May, 2011 (09.05.11) | 17 May, 2011 (17.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4065556 B

- WO 2004030900 A